(19) Europäisches Patentamt
European Patent Office
Office européen des brevets

(11) **EP 4 415 061 B1**

(12) **EUROPEAN PATENT SPECIFICATION**

(45) Date of publication and mention
of the grant of the patent:
**06.05.2026   Bulletin 2026/19**

(51) International Patent Classification (IPC):
**H10H 20/817** (2025.01)          **H10H 20/819** (2025.01)
**H10H 20/82** (2025.01)

(21) Application number: **22898358.1**

(52) Cooperative Patent Classification (CPC):
**H10H 20/817; H10H 20/819; H10H 20/82;**
H10H 20/814; H10H 20/872

(22) Date of filing: **01.11.2022**

(86) International application number:
**PCT/JP2022/040884**

(87) International publication number:
**WO 2023/095573 (01.06.2023 Gazette 2023/22)**

(54) **LIGHT-EMITTING DIODE ELEMENT**

LEUCHTDIODENELEMENT

ÉLÉMENT DE DIODE ÉLECTROLUMINESCENTE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:   **24.11.2021   JP 2021189929**

(43) Date of publication of application:
**14.08.2024   Bulletin 2024/33**

(73) Proprietors:
  • **Kyoto University
    Sakyo-ku
    Kyoto-shi
    Kyoto 606-8501 (JP)**
  • **Stanley Electric Co., Ltd.
    Meguro-ku
    Tokyo 153-8636 (JP)**

(72) Inventors:
  • **NODA, Susumu
    Kyoto-shi, Kyoto 606-8501 (JP)**
  • **KASHIWAGI, Hiroyuki
    Meguro-ku, Tokyo 153-8636 (JP)**
  • **IDE, Shunya
    Meguro-ku, Tokyo 153-8636 (JP)**
  • **IWASAKI, Tessei
    Meguro-ku, Tokyo 153-8636 (JP)**
  • **KAWAKAMI, Yasuyuki
    Meguro-ku, Tokyo 153-8636 (JP)**
  • **YOKOBAYASHI, Yusuke
    Meguro-ku, Tokyo 153-8636 (JP)**

(74) Representative: **Pritzlaff, Stefanie Lydia
    Wagner & Geyer Partnerschaft mbB
    Patent- und Rechtsanwälte
    Gewürzmühlstraße 5
    80538 München (DE)**

(56) References cited:
  CN-A- 108 511 572          CN-A- 108 511 572
  JP-A- 2007 329 468          JP-A- 2020 107 778
  JP-B1- 5 553 292            US-A1- 2019 198 727

  • LIU JIA-ZHE ET AL: "Efficiency Improvement of
    Blue LEDs Using a GaN Burried Air Void
    Photonic Crystal With High Air Filling Fraction",
    IEEE JOURNAL OF QUANTUM ELECTRONICS,
    IEEE, USA, vol. 50, no. 5, 1 May 2014
    (2014-05-01), pages 314 - 320, XP011543272,
    ISSN: 0018-9197, [retrieved on 20140319], DOI:
    10.1109/JQE.2014.2309137

## Description

Technical Field

The present invention relates to a light-emitting diode element including a photonic crystal.

Background Art

In recent years, efforts toward autonomous driving of vehicles such as automobiles or moving objects have progressed rapidly, and the demands placed on lighting equipment such as headlamps are also changed. For example, headlamps are required to have value not only as a single lamp but also as a lamp system that incorporates sensors and the like. However, for example, in automobile headlamps, light-emitting diode (LED) elements are sometimes arranged in parallel to increase output for use, but there is a problem in that it is difficult to secure a space for installing sensors and the like.

In general, spontaneous emission LEDs have a Lambertian light emission distribution, which spreads the light distribution, resulting in loss due to light that deviates from the lens in a headlamp. In order to reduce the loss of light and further increase the amount of light, it is necessary to increase the size of the lens (that is, increase an aperture ratio NA), but this is not preferable from the viewpoint of the space for the headlamp. In order to increase the amount of LED light taken in without changing the NA of the lens, it is necessary to narrow the light emission distribution of the LED light source itself in angle.

For example, JP 2015-109477 A discloses forming a structure called a moth-eye nano pattern with a sapphire substrate (NPSS) on a sapphire substrate or the like to increase light extraction efficiency.

Further, it is disclosed that depending on the period of the NPSS, it is possible to narrow a part of the light for extraction. However, the proportion of light that can be narrowed by the effect of NPSS is not high.

Liu, Jia-Zhe et al.: "Efficiency Improvement of Blue LEDs Using a GaN Burried Air Void Photonic Crystal With High Air Filling Fraction", IEEE Journal of Quantum Electronics, IEEE, USA, vol. 50, No. 5, May 2014, pages 314-320, ISSN: 0018-9197, DOI: 10.1109/JQE.2014.2309137, discloses an investigation of the efficiency enhancement of blue InGaN/GaN light-emitting diodes (LEDs) by incorporating a buried air void photonic crystal (BAVPC) layer within the epitaxial structure. As compared with the conventional patterned sapphire substrate (C-PSS) LEDs and flat sapphire substrate LEDs with BAVPC, the fabricated patterned sapphire substrate (PSS) LEDs with BAVPC exhibit the lowest full-width at half-maximum of (002) and (102) diffraction peaks, the highest light output power of 20.6 mW, and the highest external quantum efficiency of 37.4%. Remarkable performance improvement in the PSS LED with BAVPC is attributed to the better epitaxial quality with threading dislocations terminated by the BAVPC and the higher scattering at interface between GaN and air-void. By positioning the BAVPC directly below the multiple quantum wells (MQWs), it would cause the reduction in the number of trapped optical modes. The methodology optically isolates the MQWs from the underlying substrate and increases the optical output power. Moreover, threading dislocations are significantly suppressed using the BAVPC with high air filling fraction of {sim}{50%}. It is well proposed that this methodology provides a promising alternative to C-PSS LEDs.

CN 108 511 572 A discloses an LED with a photonic crystal structure. The LED comprises a nano graphical sapphire substrate, a non-doped GaN layer, an n type GaN layer, a multi-quantum well active region, a p type AlGaN electron barrier layer, a p type GaN ohmic contact layer and an ITO layer arranged successively from bottom to top, the LED further comprises a p type ohmic electrode led out of the ITO layer and an n type ohmic electrode led out of the n type GaN layer, and the reflective photonic crystal structure is prepared on the non-doped GaN layer.

Summary of Invention

Technical Problem

An object of the present invention is to provide a highly efficient light-emitting diode element having a light distribution characteristic that is highly efficiently narrowed in angle.

Solution to Problem

According to the present invention, a light-emitting diode element is provided as set forth in claim 1. Preferred embodiments of the present invention may be gathered from the dependent claims.

Brief Description of Drawings

FIG. 1A is a plan view schematically showing the upper surface of a light-emitting diode element 10 according to a first comparative example.

FIG. 1B is a cross-sectional view schematically showing a cross-sectional structure taken along the line A-A shown in FIG. 1A.

FIG. 2A is a view showing a dispersion relationship in which a horizontal axis is a wave number kx (= ksinθ) and a vertical axis is a normalized frequency a/λ.

FIG. 2B is a view showing an enlarged portion of the maximum value of TE0.

FIG. 3A is a view showing experimental results of the dependence of PL detection intensity (vertical axis) with respect to d/a (horizontal axis).

FIG. 3B is a view showing experimental results of the dependence of PL detection intensity with respect to lattice constant a.

FIG. 4 is a graph showing a comparison between the light distribution of the light-emitting diode 10 of the first comparative example (EMB1, solid line) and the light distribution of the LED of another comparative example (CMP, broken line).

FIG. 5A is a view showing that in the light-emitting diode 10 of the present comparative example, a laterally propagating low-order mode is narrowed in angle by a photonic crystal layer 21P, and a light distribution characteristic with a narrowed angle can be obtained.

FIG. 5B is a view showing that in the LED (CMP) of the other comparative example, the extraction efficiency of low-order mode light that is emitted from a light-emitting layer and propagates laterally is low.

FIG. 6A is a plan view schematically showing the upper surface of a light-emitting diode 50 of a second comparative example.

FIG. 6B is a cross-sectional view schematically showing a cross-sectional structure taken along the line A-A shown in FIG. 6A.

FIG. 7 is a flowchart showing a procedure for determining the structure of the light-emitting diode 50.

FIG. 8 is a view showing the results of waveguide mode simulation.

FIG. 9A is a view schematically showing a center position AC of a light-emitting layer 23A in the layer thickness direction and a light intensity distribution FO when the direction perpendicular to the light-emitting layer 23A is an x direction.

FIG. 9B is a view showing an electric field distribution $E_y(x)$ with respect to a position in the x direction.

FIG. 10 is a graph showing a difference $\Delta x$ with respect to a layer thickness Ts of a spacer layer 23B.

FIG. 11 is a graph showing a comparison between the light distribution of the light-emitting diode 50 of the second comparative example (EMB2, solid line) and the light distribution of the LED of the other comparative example (CMP, broken line).

FIG. 12 is a plan view schematically showing the upper surface (light emission surface) of a light-emitting diode device 60 of a third comparative example.

Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

[First comparative example]

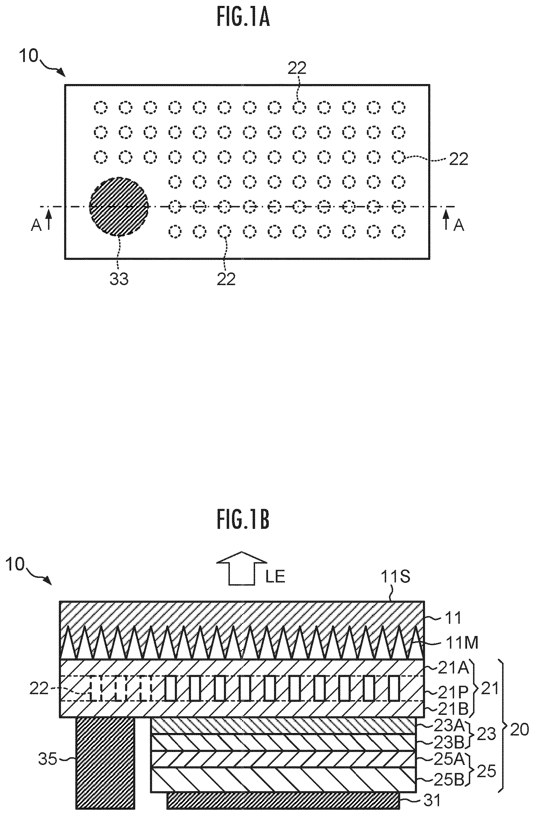

FIG. 1A is a plan view schematically showing the upper surface of the light-emitting diode element 10 according to the first comparative example, and FIG. 1B is a cross-sectional view schematically showing a cross-sectional structure taken along the line A-A shown in FIG. 1A.

The light-emitting diode element (hereinafter, simply referred to as a light-emitting diode) 10 includes a substrate of a moth-eye nano pattern (NPSS: nano pattern with sapphire substrate) (hereinafter, referred to as an NPSS substrate) 11 and a semiconductor light-emitting structural layer (hereinafter, referred to as an LED structural layer) 20 provided on the NPSS substrate 11. The LED structural layer 20 includes a first semiconductor layer 21 including a photonic crystal layer 21P, an active layer 23, and a second semiconductor layer 25.

In the present comparative example, a case where the LED structural layer 20 includes a nitride-based semiconductor layer (GaN-based semiconductor layer) has been described, but the LED structural layer 20 may be another crystalline semiconductor light-emitting structural layer that operates as an LED.

In addition, the composition, the layer thickness, the impurities, the doping concentration, and the like of each layer of the semiconductor structural layer shown below are merely examples, and can be appropriately selected, modified, and the like according to a desired characteristic.

With reference to FIGS. 1A and 1B, the photonic crystal layer 21P is a structural layer in which fine air holes 22 are two-dimensionally periodically formed in a plane parallel to the first semiconductor layer 21 and the refractive index is periodically changed.

The NPSS substrate 11 is a sapphire substrate having a light emission surface 11S from which light from the LED structural layer 20 is emitted as emitted light LE. The NPSS substrate 11 has a moth-eye structural protrusion on the surface opposite to the light emission surface 11S.

More specifically, the NPSS substrate 11 has, on the surface thereof, a protrusion structure 11M (moth-eye structure) in which, for example, conical protrusions having a period of 200 nm, a height of 150 nm, and a diameter at the bottom surface of 120 nm are periodically formed in a lattice pattern. The protrusion of the moth-eye structure 11M protrudes toward the first semiconductor layer 21. In addition, the NPSS substrate 11 has, for example, a thickness of 150 $\mu$m.

The protrusions of the moth-eye structure 11M are not limited to the above example. It is sufficient that the protrusions are periodically formed in a lattice pattern. For example, protrusions having a period of 440 nm, a height of 400 nm, and a diameter at the bottom surface of 320 nm may be formed periodically in a lattice pattern.

The size and period of the protrusions of the moth-eye structure 11M can be appropriately set depending on the emission wavelength of the LED structural layer 20, the light distribution pattern of the light-emitting diode 10, and the like. The moth-eye structure 11M allows light from the LED structural layer 20 to be extracted to the outside as narrow-angle light.

On the moth-eye structure 11M of the NPSS substrate 11, an n-GaN layer with a thickness of 5700 nm is provided as the first semiconductor layer 21. Each semiconductor layer on the first semiconductor layer 21 will be described below in the order of stacking.

The distance between the photonic crystal layer 21P provided in the first semiconductor layer 21 and the upper surface of the protrusion of the moth-eye structure 11M is 5,740 nm. The air holes 22 in the photonic crystal layer 21P are arranged with two-dimensional periodicity in a plane parallel to the first semiconductor layer 21.

More specifically, the air holes 22 are arranged at square lattice positions, have a cylindrical shape, have a lattice constant (period) of 185 nm, a height of 240 nm, and a diameter of 95 nm.

A buried layer 21B that buries the photonic crystal layer 21P is formed on the photonic crystal layer 21P. The buried layer 21B is made of n-GaN, which is an n-type semiconductor layer, and has a layer thickness of 120 nm.

Here, when the lattice constant of the photonic crystal = a, the emission wavelength = $\lambda$ (in a vacuum), and the refractive index of the base = neff, in the case of a square lattice two-dimensional photonic crystal, a $\neq$ m$\lambda$/neff is satisfied (m is a natural number), and in the case of a triangular lattice two-dimensional photonic crystal, a $\neq$ m$\lambda$ x 2/(3/2 x neff) is satisfied (m is a natural number). In this case, $\lambda$ holds true not only for the peak wavelength but also for any wavelength $\lambda$w (in a vacuum) within the full width at half maximum of the emission spectrum of the active layer. That is, when the peak of the emission spectrum is 445 nm and the full width at half maximum is 10 nm, $\lambda$ is considered to have a range of 440 nm to 450 nm (440 nm $\leq$ $\lambda$w $\leq$ 450 nm). Preferably, the present invention is a light-emitting element that emits non-resonant LED light. By forming only photonic crystals that satisfy these conditions, non-resonant light can be made to have a narrow angle.

However, even if a = m$\lambda$/neff is satisfied in the case of a square lattice two-dimensional photonic crystal, and a = m$\lambda$ x 2/(3/2 x neff) in the case of a triangular lattice two-dimensional photonic crystal, if the supplied current value is equal to or less than a certain value, the non-resonant light can remain as narrow-angle light. In this case, when a power supply (not shown) connected to the light-emitting diode 10 supplies a current value that does not cause resonant light to be generated, similarly to the wide-angle light component (emission angle greater than 20°), the narrow-angle light component (emission angle of 20° or less) can also be used as a light-emitting element that emits non-resonant LED light.

The light-emitting layer 23A is formed on the first semiconductor layer 21. The light-emitting layer 23A is a multi-quantum well structural layer (hereinafter, referred to as an MQW layer) having a five-layer structure in which GaN barrier layers and InGaN well layers are alternately stacked.

A spacer layer 23B is formed on the light-emitting layer 23A. The spacer layer 23B is made of GaN and has a layer thickness of 6 nm.

A second semiconductor layer 25 is formed on the spacer layer 23B. More specifically, the second semiconductor layer 25 includes an electron blocking layer 25A and a p-GaN layer 25B which is a p-type semiconductor layer formed on the electron blocking layer 25A.

The electron blocking layer 25A is made of AlGaN and has a layer thickness of, for example, 10 nm. The p-GaN layer 25B has a layer thickness of, for example, 116 nm.

In the present specification, a layer including the light-emitting layer 23A and the spacer layer 23B is referred to as the active layer (core layer) 23. In addition, the first semiconductor layer 21 and the second semiconductor layer 25 sandwiching the active layer 23 from both sides function as a first cladding layer and a second cladding layer, respectively.

Since the first semiconductor layer (first cladding layer) 21 includes the photonic crystal layer 21P, that is, the air holes 22, the refractive index is smaller than that of the base semiconductor (GaN in the present comparative example), and therefore, the effective refractive index is smaller than the effective refractive index of the active layer (core layer) 23.

In addition, the electron blocking layer 25A is composed of a semiconductor (AlGaN in the present comparative example) with a larger band gap and smaller refractive index than the active layer 23 (that is, the spacer layer 23B of the active layer 23), the effective refractive index of the second semiconductor layer (second cladding layer) 25 is smaller than the effective refractive index of the active layer 23.

The first semiconductor layer 21 and the second semiconductor layer 25 have a function similar to, for example, a cladding of an optical fiber, that is, a function of confining light guided in the active layer (core layer) 23. The first semiconductor layer 21 may be composed of a plurality of semiconductor layers having mutually different compositions. In addition, the second semiconductor layer 25 may also be composed of a plurality of semiconductor layers having mutually different compositions.

In addition, the first semiconductor layer 21 is an n-type semiconductor layer, and the second semiconductor layer 25 is a p-type (opposite conductivity type to the first semiconductor layer 21) semiconductor layer, but the first semiconductor layer 21 and the second semiconductor layer 25 may have an i-layer or an undoped layer. For example, the electron blocking layer 25A in the second semiconductor layer 25 may be configured as an undoped layer.

A p-electrode 31 is provided on the p-GaN layer 25B. The p-electrode 31 is formed, for example, as a Ni/Au structure (Au is a surface layer) made of Ni (nickel) formed on the p-GaN layer 25B and Au (gold) formed on the Ni.

The p-electrode 31 can be a metal layer that is in ohmic contact with the p-GaN layer 25B. For example, a configuration using an ITO electrode/Ag reflective film with high reflectance is used. In addition, a semiconductor layer (for example, a highly doped layer) that can easily make ohmic contact with the metal layer may be provided on the p-GaN layer 25B.

In addition, an n-electrode 35 is provided on the exposed surface of the first semiconductor layer 21 on which the buried layer 21B is partially exposed by etching. The n-electrode 35 is in ohmic contact with the first semiconductor layer 21. The n-electrode 35 has, for example, an Al (aluminum)/Pt (platinum)/Au structure (Au is a surface layer).

As shown in FIG. 1A, the light-emitting diode 10 is placed on a substrate or block provided with a wiring circuit, with the p-electrode 31 and the n-electrode 35 as a lower surface. By applying current between the p-electrode 31 and the n-electrode 35, the light-emitting diode 10 emits light.

[Manufacturing Process of Light-emitting diode 10]

An example of a manufacturing process for the light-emitting diode 10 which is a photonic crystal LED, will be described below.

First, the NPSS substrate 11 was prepared in which the moth-eye structure 11M with a period of 356 nm was formed on a sapphire substrate. Then, the n-GaN layer was grown on the moth-eye structure 11M of the NPSS substrate 11 by metal organic chemical vapor deposition (MOCVD).

Next, as a film for a hard mask, a layer of SiO2, SiN, and the like was formed on the n-GaN layer by a method such as sputtering or plasma CVD. Subsequently, a resist film was formed on a hard mask film, and a square lattice resist pattern with the lattice constant of 185 nm and a hole diameter of 92.5 nm was formed by electron beam lithography.

By using the resist pattern as a mask, a hard mask was dry-etched with a fluorocarbon (CF) gas to form the hard mask. Through the formed hard mask, the n-GaN layer was further etched to a depth of 240 nm with a chlorine (Cl)-based gas to form holes arranged in a square lattice.

After etching, crystal growth of the n-GaN layer was performed again by the MOCVD device. Through this crystal growth, the photonic crystal layer 21P having air holes 22 arranged at square lattice positions and the buried layer 21B burying the photonic crystal layer 21P were formed. An n-GaN layer 21A is formed between the photonic crystal layer 21P and the NPSS substrate 11.

Subsequently, the light-emitting layer 23A, the spacer layer 23B, the electron blocking layer (p-cladding layer) 25A, and the p-GaN layer 25B were successively grown on the buried layer 21B.

Further, the p-electrode 31 was formed on the p-GaN layer 25B by using a photolithography method. In addition, by the photolithography method and etching, a part of the buried layer 21B was exposed, and the n-electrode 35 was formed on the exposed buried layer 21B.

[Narrowing Angle with NPSS Substrate]

In the above, the case where the NPSS substrate 11 is a sapphire substrate has been described as an example, but the same effect can be achieved regardless of the material as long as the NPSS substrate 11 has a cone-shaped or frustum-shaped (hereinafter, collectively referred to as a conical shape) periodic tapered protrusion structure. For example, a semiconductor substrate such as GaN or Si (silicon) may be used. In the present invention, materials other than sapphire are also referred to as NPSS for convenience.

Although the photonic crystal layer 21P has a function of radiating narrow-angle light, the NPSS substrate 11 is required to have a cone-shaped periodic structure that can extract narrow-angle light as it is. For that purpose, (i) a cone-shaped periodic structure that does not diffract the light that is narrowed in angle by the photonic crystal and suppresses the reflection at the interface between the photonic crystal layer 21P and the NPSS substrate 11 or (ii) a cone-shaped periodic structure in which the light that is narrowed in angle from the photonic crystal is diffracted to have a predetermined angle or less is required.

In the following, a case will be described in which light that is narrowed in angle by the photonic crystal layer 21P is incident on the NPSS substrate 11.

The conditions for (i) to hold are as follows.

In a case of the wavelength λ (wavelength in a vacuum), the period P of the cone-shaped protrusion of the NPSS substrate 11, the incidence angle φ (in a case of being perpendicular to the NPSS substrate 11: φ = 0), the medium refractive index $n_s$, the substrate refractive index n, and the degree m, the conditions for not causing diffraction are as follows.

$$\left(n_s - n\sin\phi\right)P < m\lambda \qquad \text{Formula (1)}$$

Here, when Formula (1) is modified, a periodic condition P that does not cause diffraction is as follows.

$$P \leq \frac{m\lambda}{n_s - n\sin\phi} \qquad \text{Formula (2)}$$

Here, the wavelength λ is set to 445 nm, and the period at which no diffraction occurs is determined. For example, when a photonic crystal is designed to generate light at φ = 10°, it is assumed to satisfy a condition in which NPSS does not diffract the light at a slightly larger angle of φ = 20°. This is because, for example, when used as a headlamp, the component of φ = 20° also greatly contributes to improving the output, and therefore a part of the light other than the narrow-angle light generated by the action of the photonic crystal also plays a role in improving the extraction efficiency.

When incident on an NPSS structure formed of GaN (refractive index $n_s$ = 2.5) and sapphire (refractive index n = 1.8), the period P at which no diffraction occurs is 236 nm or less.

Assuming that the wavelength λ = 445 nm, the following Formula (3) is obtained from the general relationship between period and wavelength.

$$\frac{P}{\lambda} \leq 0.531 \qquad \text{Formula (3)}$$

In addition, the periodic pattern must have a conical shape and form a refractive index gradient. By setting, as required by the invention, the cone-shaped period to $P < \lambda/n_s$, light does not feel the unevenness of NPSS, but feels as if the refractive index is gradient between GaN (refractive index $n_s$ = 2.5) and sapphire (refractive index n = 1.8). By being treated as a surface with the refractive index gradient, Fresnel reflection is suppressed compared to a flat surface without an uneven structure. The height of the pattern is preferably at least $\lambda/2n_s$ (wavelength λ) or more, and more preferably $\lambda/n_s$ (wavelength λ) or more. In the case of the above example, by satisfying $P < \lambda/n_s$, Formula (3) is also satisfied at the same time.

Next, the conditions for (ii) to hold will be described.

A photonic crystal is designed to generate light at φ = 10°. This is because, for example, when used as a headlamp, the component of φ = 20° also greatly contributes to improving the output, and therefore a part of the light other than the narrow-angle light of the photonic crystal is also extracted and improved. Since the NPSS receives both light that is narrowed in angle by the photonic crystal and light that is not narrowed in angle, it is assumed that the combined light will be used. Assuming that the protrusions of the NPSS structure are arranged in a hexagonal lattice, the condition for the diffracted light generated in an angle $\theta_{out}$ direction is given by the following Formula (4).

$$n_s\frac{2\pi}{\lambda}\sin\theta_{in} - n\frac{2\pi}{\lambda}\sin\theta_{out} = m_1\left(\frac{2\pi}{P}\right) + \frac{1}{2}m_2\left(\frac{2\pi}{P}\right) \qquad \text{Formula (4)}$$

Here, $m_1$ and $m_2$ are degrees. As a representative value of a low-order degree at which light can be diffracted, it is considered that $m_1$ = -1 and $m_2$ = 1. By using Formula (4), when $\theta_{in} \leq 20°$, a relationship between $\lambda$ and wavelength that satisfies the condition $-20° \leq \theta_{out} \leq 20°$ that the absolute value of the emission angle is smaller than 20° is calculated, the following Formula (5) is obtained.

$$0.817 \leq \frac{P}{\lambda} \leq 1 \qquad \text{Formula (5)}$$

Therefore, in the NPSS configuration (ii) above, the narrow-angle light of 20° or less increased by the action of the photonic crystal can be emitted as narrow-angle light of $\varphi$10° to 20° without being expanded even if the light passes through the NPSS.

Further, the light incident on the NPSS configuration includes a component that is reflected, but the light is reflected by the electrodes or the like formed on the opposing surface and is incident on the NPSS again. Since the NPSS reflects light at an angle different from the incidence angle, a part of the light that is incident again on the NPSS is also extracted as narrow-angle light at the same time, significantly increasing the output of the narrow-angle light. In the periodic structure of NPSS, the dotted protrusions can be arranged in a hexagonal lattice or a square lattice.

The wavelength $\lambda$ and period P of the NPSS structure in an example not forming part of the invention as claimed are P/$\lambda$ = 0.988, where $\lambda$ = 445 nm and period P = 440 nm, which satisfies Formula (4). Therefore, Formula (4) falls under the configuration (ii) above.

Further, another comparative example without the NPSS structure was prepared and the light output was compared. The other comparative example has the same configuration as the present comparative example except that the sapphire substrate has a flat surface on which no NPSS structure is formed. As a result, the light output was 150 mW in the other comparative example and 220 mW in the present comparative example, which was confirmed through experiments that the light output was 1.5 times or more higher than that of a flat substrate without an uneven structure.

Next, taking a blue LED with a wavelength $\lambda$ = 445 nm (full width at half maximum 10 nm) as an example, the configuration and pattern selection method of the internal photonic crystal that narrows the angle will be described. The band gap in the photonic crystal is calculated, and for a calculation method or the like, reference can be made to "Introduction to Photonic Crystal (Author: Kazuaki Sakoda, Morikita Publishing Co., Ltd.)" or the like.

The photonic crystal has the ability to exclude light of a certain frequency from within the crystal, and the frequency range thereof can be freely set, which is called a photonic band gap.

Here, the dispersion relationship is determined from photonic band gap calculation. When the medium refractive index of the photonic crystal medium is n = 2.5 (for example, GaN), the refractive index of the photonic crystal air hole medium is the atmosphere n = 1, the lattice constant a (or period) and the air hole diameter d are d/a = 0.5, and air holes are arranged in a square lattice, the dispersion relationship of transverse electric (TE) mode is calculated.

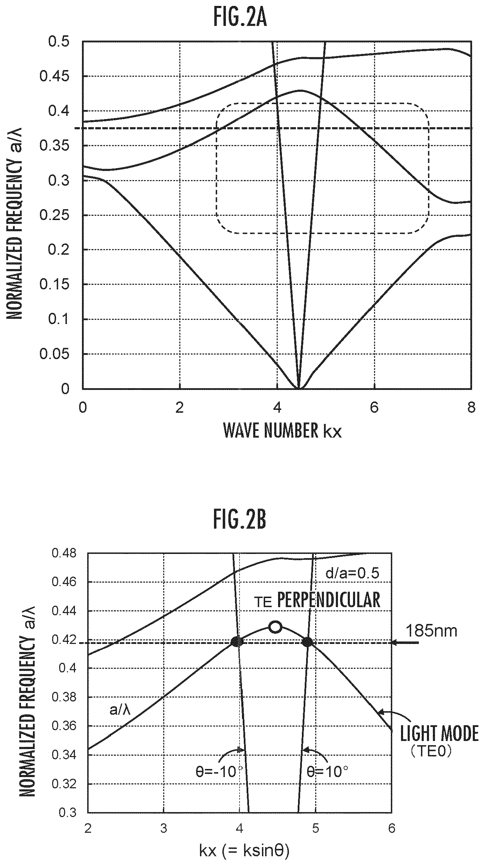

FIG. 2A is a view showing a dispersion relationship in which a horizontal axis is a wave number kx (= ksin$\theta$) and a vertical axis is a normalized frequency a/$\lambda$. Here, the diffraction angle is $\theta$ and the wave number k = $2\pi/\lambda$. Here, attention is paid to the lowest order TE0 among a plurality of TE modes.

FIG. 2B is an enlarged view of the maximum value portion of TE0. As shown in FIG. 2B, matching the normalized frequency to the light mode end portion (white circle in the drawing) corresponds to extracting narrow-angle light in the 0° direction.

Here, the design of the photonic crystal layer 21P will be considered assuming that narrow-angle light is allowed to be $\theta$ = -10° to 10°. In FIG. 2B, the diffraction lines obtained at $\theta$ = -10° and $\theta$ = 10° are plotted.

A lattice constant design value of 185 nm is obtained from the normalized frequency of 0.415 at a location (black circle in the drawing) where the light mode (TEO) and the diffraction lines intersect. Therefore, the photonic crystal layer 21P may be configured by arranging the air holes 22 in a square lattice with an air hole diameter d = 92.5 nm and a lattice constant a = 185 nm, and arranged in a 1 mm square in-plane area. The air hole arrangement of the photonic crystal layer 21P is not limited to a square lattice, but can be appropriately selected from a triangular lattice, a hexagonal lattice, or the like, and can be obtained by the same procedure.

The design value may be determined by the intersection of the diffraction lines and a theoretical value, but may be determined after actually manufacturing a plurality of photonic crystal structures with slightly different lattice constants under the conditions.

For example, by forming an LED with a photonic crystal and measuring the photo-luminescence (PL) intensity on the axis, it is also possible to obtain optimal values for the lattice constant a and the diameter d of the air holes 22 so that the peak value of the intensity is within a desired range.

By determining the lattice constant a of the photonic crystal and the diameter d of the air holes 22, it is possible to determine the angle of the narrow-angle light produced by the photonic crystal (angle at peak intensity value), and in the case of the above condition (ii), it is also possible to determine the period of the protrusions of the NPSS by making $\theta$in

slightly wider than the angle of the peak value (peak value + 10°).

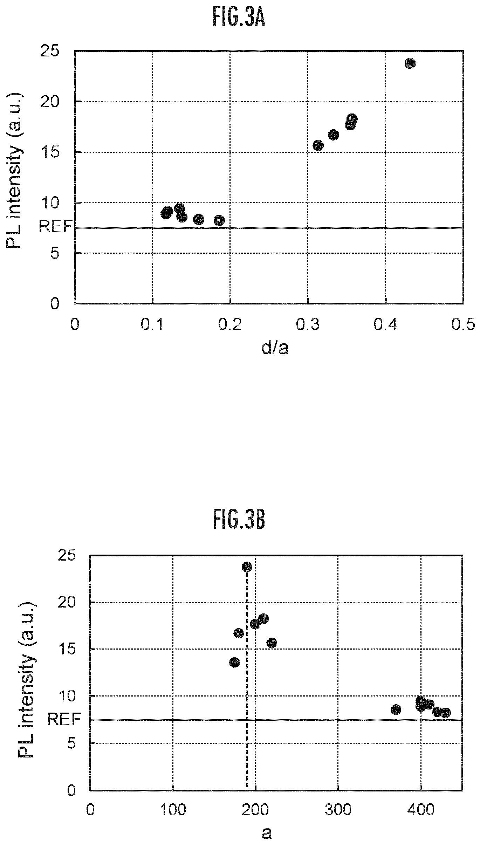

FIG. 3A is a view showing experimental results of the dependence of PL detection intensity (vertical axis) with respect to d/a (horizontal axis). In addition, FIG. 3B shows experimental results of the dependence of PL detection intensity (vertical axis) with respect to the lattice constant a (horizontal axis). A reference level (REF) of PL intensity is shown in FIGS. 3A and 3B.

As a result of the study, from the experimental results of FIG. 3A, it was found that the PL intensity increases as d/a increases, and that d/a is preferably 0.3 or more ($0.3 \leq$ d/a). In addition, from the experimental results of FIG. 3B, it was found that the PL intensity had a peak value depending on the lattice constant a. Based on the experimental results, the lattice constant can be determined to be 190 nm (broken line in FIG. 3B) in order to maximize the PL intensity.

As described above, d/a (= air hole diameter/lattice constant) in the photonic crystal layer 21P of the present comparative example is 0.3 or more, and in the TE0 mode, the air holes 22 are formed at the period a for extracting narrow-angle light within $\pm 10°$ ($-10° \leq \theta \leq 10°$).

In addition, the required height of the air holes 22 in the photonic crystal layer 21P will be described. In general, a region with an optically high refractive index such as a light-emitting layer (for example, GaN, n = 2.5) is called a core, and a surrounding region with a low refractive index including a photonic crystal layer ($n \leq 2.4$) is called a cladding.

Considering the waveguide around the light-emitting layer, the light intensity of the cladding takes an evanescent light distribution that decreases exponentially with distance. For the transverse electric(TE) mode in which the electric field vibrates in the horizontal direction of the waveguide, a penetration depth q of evanescent light in a mode corresponding to the lowest order TE0 mode is considered. An intensity distribution I(x) of the evanescent light at the light intensity $I_o$ and a distance x is given by Formula (6).

$$I(x) = I_0 \exp(-\frac{2x}{q}) \qquad \text{Formula} (6)$$

For efficient interaction with the photonic crystal layer 21P, sufficient interaction can be achieved if the height is equal to or greater than the penetration depth q of the evanescent light. From this, it is preferable that the relationship between the penetration depth q and a height h of the photonic crystal layer 21P satisfies Formula (7).

$$h \geq q \qquad \text{Formula} (7)$$

From the numerical analysis of Formulas (6) and (7), it was estimated that a penetration depth q of evanescent light was 60 nm. From the above, it is preferable that the height of the photonic crystal layer 21P is h $\geq$ 60 nm.

In other words, the height of the air holes 22 is preferably equal to or greater than the penetration depth q of the evanescent light in the TE0 mode light from the light-emitting layer 23A.

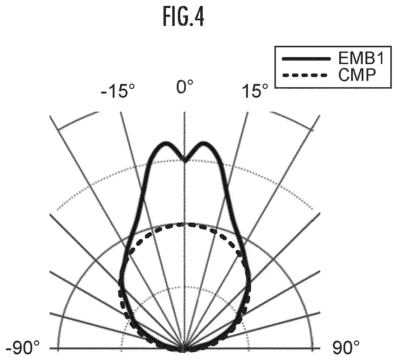

FIG. 4 is a graph showing a comparison between the light distribution of the light-emitting diode 10 of the first comparative example (EMB1, solid line) and the light distribution of the LED of the other comparative example (CMP, broken line).

The LED (CMP) of the other comparative example differs from the light-emitting diode 10 (EMB1) in that the LED (CMP) does not have the photonic crystal layer 21P, but the other configurations are the same as the light-emitting diode 10.

As shown in FIG. 4, in the light-emitting diode 10 of the present comparative example, it can be seen that the narrow-angle light component within $\pm 15°$ has increased significantly compared to the conventional LED, and a light-emitting diode with a narrow-angle light distribution characteristic has been realized.

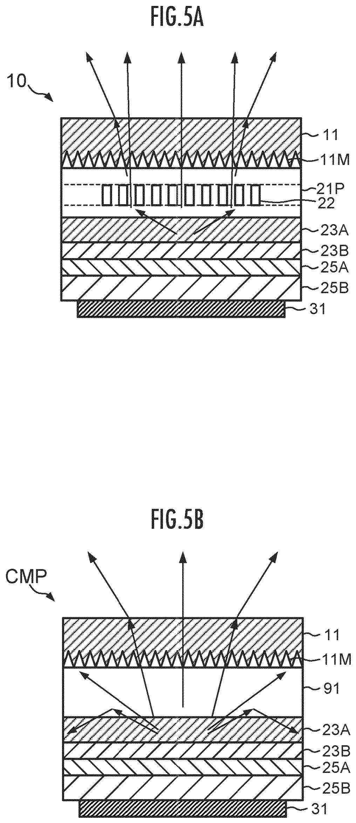

As shown in FIG. 5A, in the light-emitting diode 10 of the present comparative example, the laterally propagating low-order mode (arrow in the drawing) is narrowed in angle by the photonic crystal layer 21P, narrow-angle light is maintained by the NPSS substrate 11, and a narrow-angle light distribution characteristic is obtained.

On the other hand, as shown in FIG. 5B, in the other comparative example LED (CMP), although the NPSS substrate 11 is included, a photonic crystal structure is not provided in an n-GaN layer 91 between the light-emitting layer 23A and the NPSS substrate 11, and the extraction efficiency of low-order mode light that is emitted from the light-emitting layer and propagates laterally is low (arrow in the drawing).

Therefore, according to the light-emitting diode 10 of the present comparative example, the photonic crystal layer 21P and the NPSS substrate 11 can efficiently extract the laterally propagating light in the LED, and it is possible to realize a highly efficient light-emitting diode element having a narrow-angle light distribution characteristic.

[Second comparative example]

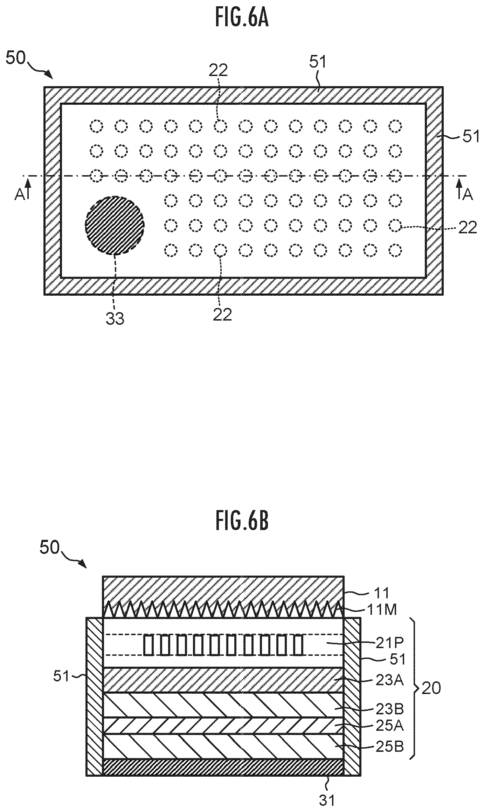

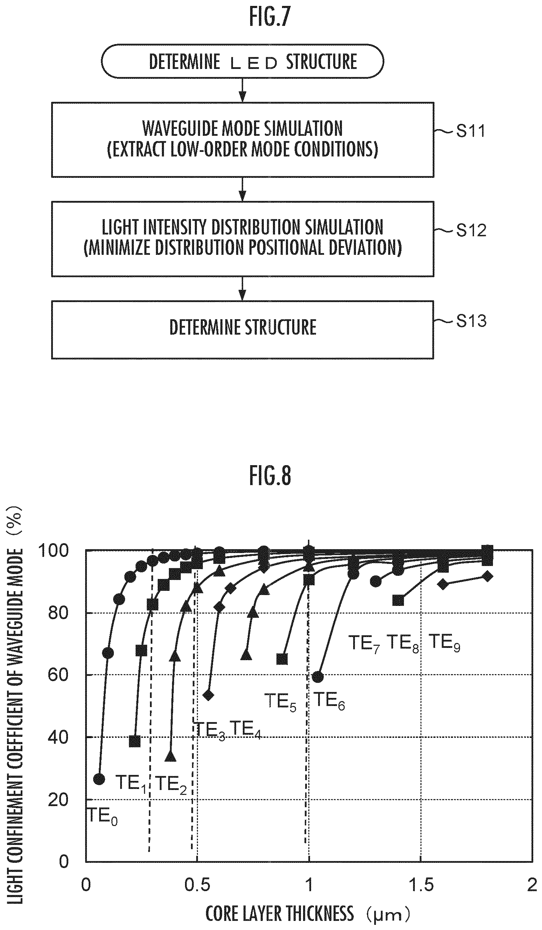

FIG. 6A is a plan view schematically showing the upper surface of the light-emitting diode 50 of the second comparative example, and FIG. 6B is a cross-sectional view schematically showing the cross-sectional structure taken along the line A-A shown in FIG. 6A. In addition, FIG. 7 is a flowchart showing a procedure for determining the structure of the light-emitting diode 50.

As shown in FIGS. 6A and 6B, in the light-emitting diode 50 according to the second comparative example, the LED structural layer 20 has a rectangular parallelepiped shape, and a reflective film 51 is formed to cover all sides of the LED structural layer 20 of the light-emitting diode 50.

It is sufficient that the reflective film 51 is formed so as to cover at least four sides of the light-emitting layer 23A in the LED structural layer 20.

In an LED element, a region with an optically high refractive index such as a light-emitting layer (for example, n =2.5 to 2.7) and the like is called a core, and a surrounding region with a low refractive index including a photonic crystal portion (for example, $n \leq 2.4$) is called a cladding.

In an LED element with a sufficiently thick core film thickness (for example, several tens of $\mu$m or more), there are many modes (several tens or more) that can be handled by geometric optics. Therefore, the light in the light-emitting layer has all angular components and is emitted and guided to the waveguide, resulting in a wide range of angular dispersion of diffraction angles at the time of extraction. On the other hand, if the film thickness of the core region is limited, there can be only solutions that are acceptable in terms of wave optics, and therefore the number of light modes is limited.

Here, the number of light modes is obtained. When approximated by a waveguide with three layers of core and cladding, the electric field distribution $E_y(x)$ of light traveling in a z direction (lateral direction) among xyz directions is given by Formula (8).

$$E_y(x) = \begin{cases} A\exp(-ux) & (x \geq 0) \\ A\cos(vx)+B\sin(vx) & (-a \leq x \leq 0) \\ \{A\cos(va)-B\sin(va)\}\exp\{w(x+a)\} & (x \leq -a) \end{cases} \qquad \text{Formula}(8)$$

However, $u = \sqrt{\beta^2 - n_1^2 k^2}$, $v = \sqrt{kn_1^2 - \beta^2}$, $w = \sqrt{\beta^2 - k^2 n_2^3}$, $\beta$ is propagation constant

Here, a is the core layer thickness, k is the wave number, and $n_1$ to $n_3$ are the refractive indices of the respective layers. Here, the unique formula converted from Maxwell's formula to H(z) and obtained from the continuity condition of H(z) is given by Formula (9).

$$\tan va = \frac{v(w+u)}{v^2 - wu} \qquad \text{Formula (9)}$$

The solution to the unique formula is obtained from the intersection of the graphs of Formula (8). The propagation constant depending on the layer thickness conditions of the waveguide can be analytically obtained. Thereafter, the proportion of optical power confined in the core is calculated. This value is called a light confinement coefficient f and is given by Formula (10).

$$f = \frac{\int_{-a}^{0}|E_y(x)|^2 dx}{\int_{-\infty}^{\infty}|E_y(x)|^2 dx} = \frac{a + \frac{u}{u^2+v^2} + \frac{w}{w^2+v^2}}{a + \frac{1}{u} + \frac{1}{w}} \qquad \text{Formula (10)}$$

When a waveguide mode simulation is performed regarding the existing modes and the light confinement coefficient f, the results shown in FIG. 8 are obtained (FIG. 7, step S11).

For example, when the core layer thickness is 1 $\mu$m, the number of modes can be set to 6 (TEO to TE5), when the core layer thickness is 500 nm, the number of modes can be set to 3 (TEO to TE2), and when the core layer thickness is 360 nm, the number of modes can be set to 2 (TEO, TE1).

By limiting to only the low-order mode (the lowest-order mode is TE0), it is possible to reduce angular variation within the waveguide.

From FIG. 8, if a region with a high light confinement coefficient (particularly, TE0 is 90% or more) is selected and the layer thickness is selected, only a small number of low-order modes within six will propagate in the waveguide. That is, in the present comparative example, the core layer is formed under the conditions that the number of modes is within six (TEO to TE5) and the light confinement coefficient is 90% or more in TE0.

For example, when the core layer thickness is 360 nm, the light confinement coefficient f reaches 97% in TE0 and 90% in TE1. However, under these conditions alone, the loss increases each time propagation within the waveguide is repeated, and the light is attenuated.

In order to increase recombination light emission efficiency and suppress light attenuation, it is important to align the center of the light-emitting layer 23A with the center of the light intensity distribution. A light intensity distribution simulation was performed to estimate the relationship between the center position of the light intensity distribution and the center coordinates of the light-emitting layer (FIG. 7, step S12).

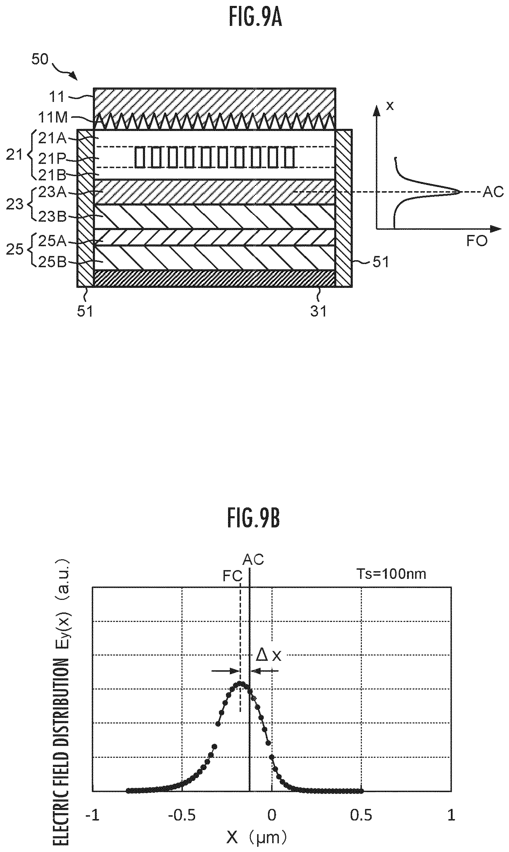

FIG. 9A is a view schematically showing the center position (center line: AC) of the light-emitting layer 23A in the layer thickness direction and the light intensity distribution FO when the direction perpendicular to the light-emitting layer 23A (orientation to the NPSS substrate 11) is the x direction.

In addition, FIG. 9B is a view showing the electric field distribution $E_y(x)$ with respect to a position in the x direction. The difference $\Delta x$ in the peak position of the electric field distribution $E_y(x)$ with respect to the center position AC of the light-emitting layer 23A is schematically shown.

The layer thickness is finally determined to minimize this difference $\Delta x$ (FIG. 7, step S13). In the present comparative example, it is assumed that the total layer thickness of the active layer (core layer) 23 (light-emitting layer 23A + spacer layer 23B) and the buried layer 21B on the photonic crystal 21P is 500 nm, and optimization was performed by using this condition as an example.

FIG. 9B shows the light intensity distribution of TE0 mode light (electric field distribution $E_y(x)$) when the layer thickness Ts of the spacer layer 23B is 100 nm, and shows the positional relationship with the center AC of the light-emitting layer 23A. It can be seen that the deviation $\Delta x$ of the peak position FC of the electric field distribution $E_y(x)$ from the center AC of the light-emitting layer 23A is about 40 nm.

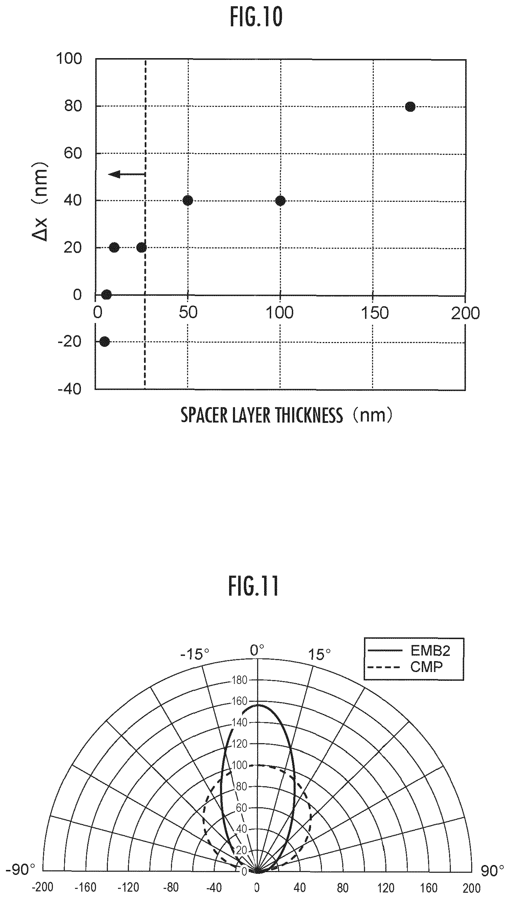

FIG. 10 is a graph showing the difference $\Delta x$ with respect to the layer thickness Ts of the spacer layer 23B. It can be seen that $\Delta x$ increases as the layer thickness Ts of the spacer layer 23B increases. Since $\Delta x = 0$ when the layer thickness Ts of the spacer layer 23B is around 5 to 6 nm, optimization can be achieved with this layer thickness Ts.

As described above, by performing the waveguide mode simulation to extract conditions under which only a small number of low-order modes propagate within the waveguide (FIG. 7, step S11) and by aligning the center of the light-emitting layer 23A with the center of the light intensity distribution for the guided light of the low-order mode, especially the TE0 mode light, by the light intensity distribution simulation (FIG. 7, step S12), it is possible to provide a light-emitting diode having high light emission efficiency and a narrow-angle light distribution characteristic.

As described above, by forming a core with a high refractive index including a light-emitting layer and a cladding with a low refractive index with a photonic crystal portion and other layers such as the electron blocking layer 25A, it is possible to efficiently produce propagating light that is narrowed in angle in the photonic crystal portion.

(Reflective Film)

The reflective film 51 provided on the side surface of the LED structural layer 20 will be described below. Here, an LED is assumed, in which the emission wavelength $\lambda$ is 445 nm and the layer thickness of the active layer (core layer) 23 including the light-emitting layer 23A is 1 $\mu$m. In addition, as described above, the case where there are six TE modes will be described as an example.

By using the propagation constant calculated from the simulation, the reflection angles when reaching the waveguide end surface (side surface) can be estimated as 84.9° for TE0, 79.9° for TE1, 74.8° for TE2, 69.6° for TE3, 64.2° for TE4, 58.8° for TE5, respectively.

When these six waveguide modes reach the end surface of the waveguide (that is, the side surface of the LED structural layer 20), the incidence angle $\alpha$ of light with respect to the end surface is 5.1° for TE0, 10.1° for TE1, 15.2° for TE2, 20.4° for TE3, 25.8° for TE4, and 31.2° for TE5.

Here, the total reflection angle of light from the semiconductor layer to the air interface is 23.6°, and under the condition of an incidence angle equal to or greater than the total reflection angle, the light is reflected even in the absence of a reflective periodic structure. Therefore, it is important that among the six modes, the low-order mode light up to TE3 is reflected by the reflective film 51.

The reflective film 51 can be realized by forming a dielectric multilayer film such as $TiO_2/SiO_2$ (titanium oxide film/silicon oxide film). When a metal film is used, there are problems including absorption loss during reflection, and it is important to use a dielectric multilayer film.

Here, conditions for efficiently reflecting the mode will be described. It is considered that the light mode of the waveguide reaches the end portion of the substrate and enters at the incidence angle $\alpha$ described above. The conditions under which reflected light is strengthened by a multilayer film formed, on the side surface of the semiconductor layer, of a high refractive index material with a film thickness $d_h$ (refractive index: $n_h$) and a low refractive index material with a film thickness $d_l$ (refractive index: $n_l$) are given by Formula (11).

$$2n_h d_h \cos\alpha = \left(m + \frac{1}{2}\right)\lambda \qquad \text{Formula}(11)$$

Here, m is an integer. Here, if m=0, Formula (12) is obtained.

$$n_h d_h \cos\alpha = \frac{\lambda}{4} \qquad \text{or} \qquad n_h d_h \cos\alpha = \frac{3\lambda}{4} \qquad \text{Formula}(12)$$

High reflectance is achieved by designing the film thickness to be $\lambda$s/4 ($\lambda$s is the wavelength within the medium).

In addition, m may be set to 1 and the film thickness may be 3$\lambda$s/4.

Further, by replacing $n_h$ with $n_l$ and $d_h$ with $d_l$ in Formulas (11) and (12), it is possible to determine the film thickness condition of the low refractive material with a similar method.

The dielectric multilayer film is basically designed to have a film thickness of $\alpha$ = 5.1°, focusing on the lowest order TE0 mode, but the incidence angle $\alpha$ may be changed to match the reflection of a plurality of low-order modes such as TE1 ($\alpha$: 10.1°), TE2 ($\alpha$: 15.2°), and TE3 ($\alpha$: 20.4°), and a plurality of types of multilayer films may be formed.

Further, if the size (width $L_x$ and height $L_y$) of the rectangular LED structural layer 20 is determined from an integral multiple of the wavelength $\lambda$s in the medium, that is, $L_x = n_x \lambda$s, $L_y = n_y \lambda$s ($n_x$ and $n_y$ are integers), a better amplification effect can be obtained.

FIG. 11 is a graph showing a comparison between the light distribution of the light-emitting diode 50 of the second comparative example (EMB2, solid line) and the light distribution of the LED of the other comparative example (CMP, broken line).

The LED (CMP) of the other comparative example differs from the light-emitting diode 50 (EMB2) in that the LED (CMP) does not have the photonic crystal layer 21P and the reflective film 51, but the other configurations are the same as the light-emitting diode 50.

As shown in FIG. 11, in the light-emitting diode 50 of the second comparative example, the narrow-angle light component within ±15° has increased significantly compared to the conventional LED, and narrowing in angle is achieved. In addition, even when compared with the light-emitting diode 10 of the first comparative example (FIG. 4), it can be seen that a light-emitting diode having a narrower-angle light distribution characteristic has been realized.

[Third comparative example]

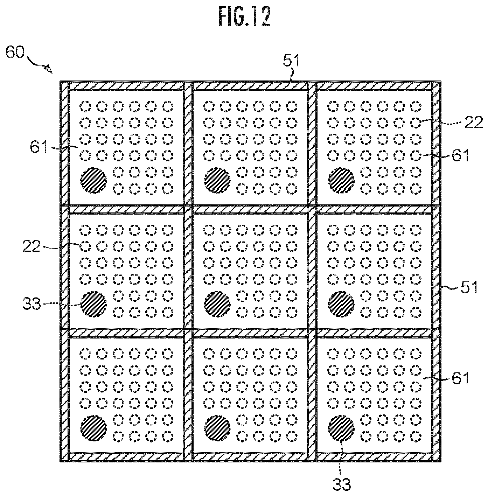

FIG. 12 is a plan view schematically showing the upper surface (light emission surface) of the light-emitting diode device 60 of a third comparative example.

The light-emitting diode device 60 has the same structure as the light-emitting diode 50 of the second comparative example, but is configured by arranging a plurality of light-emitting diodes 61 with smaller element sizes adjacent to each other in a matrix.

If a photonic crystal is manufactured in a large area, the resistance becomes high due to the air holes in the photonic crystal, and current diffusion may become difficult. In the present comparative example, each of the plurality of light-emitting diodes 61 has a small size that allows sufficient current diffusion.

Therefore, each of the light-emitting diodes 61 has uniform and highly efficient light emitting characteristics. In addition, by making the overall size of the light-emitting diode device 60 comparable to, for example, the single light-emitting diode 50 of the second comparative example, a light-emitting diode device having a narrow-angle light distribution, and uniform and highly efficient light emitting characteristic can be realized.

In the above examples, a light-emitting diode including a photonic crystal layer with a single lattice structure has been described, but the present invention is not limited thereto, and can also be applied to a light-emitting diode including a photonic crystal layer with a multiple lattice structure.

In addition, in the above examples, a photonic crystal light-emitting diode made of nitride semiconductor has been described, but the present invention is not limited thereto, and can also be applied to a photonic crystal light-emitting diode made of other crystalline semiconductors.

In addition, the numerical values in the above examples are merely illustrative, and can be modified and applied as appropriate depending on the composition of the semiconductor used, the emission wavelength, and the like, within the conditions defined by the appended claims.

**Claims**

1.  A light-emitting diode element (10, 50, 61) comprising:

    a substrate (11) with a moth-eye nano pattern (11M) on a surface of the substrate (11) in which cone-shaped protrusions are periodically formed and are arranged in a lattice;
    a first semiconductor layer (21) formed on the moth-eye nano pattern (11M) and having a photonic crystal layer (21P);
    an active layer (23) formed on the first semiconductor layer (21) and having a light-emitting layer (23A); and
    a second semiconductor layer (25) formed on the active layer (23),
    **characterized in that**

    $$P < \lambda/ns$$

    is satisfied,
    wherein a period of the protrusions is P, an emission wavelength of the light-emitting layer (23A) is λ, and a refractive index of a medium on a light-emitting layer side of the moth-eye nano pattern (11M) is ns.

2.  The light-emitting diode element according to claim 1,

    wherein the photonic crystal layer (21P) has only photonic crystals satisfying a square lattice arrangement and a ≠ mλw/neff for any natural number m, or the photonic crystal layer (21P) has only photonic crystals satisfying a triangular lattice arrangement and a ≠ mλw x 2/(3/2 x neff) for any natural number m,
    wherein a lattice constant of the photonic crystal layer (21P) is a, a refractive index of a material of the first semiconductor layer (21) is neff, and an arbitrary wavelength in a vacuum within a full width at half maximum of an emission spectrum of the light-emitting layer (23A) is λw.

3.  The light-emitting diode element according to claim 1 or 2,

    wherein a first layer (21P) and a second layer (25) having an effective refractive index lower than the active layer (23) are formed with the active layer (23) sandwiched therebetween, and
    the photonic crystal layer (21P) is the first layer (21P).

4.  The light-emitting diode element according to any one of claims 1 to 3,

    wherein the photonic crystal layer (21P) has air holes (22) having a cylindrical shape and arranged at square lattice point positions,
    wherein 0.3 ≤ d/a is satisfied,
    wherein a lattice constant of the air holes (22) is a, and a diameter of the air holes (22) is d.

5.  The light-emitting diode element according to claim 4,
    wherein the first semiconductor layer (21) is made of GaN, and a depth of the air holes (22) of the photonic crystal layer (21P) is equal to or more than a penetration depth of evanescent light in TE0 mode light from the light-emitting layer (23A).

6.  The light-emitting diode element according to any one of claims 1 to 3,
    wherein the active layer (23) includes a spacer layer (23B) formed on the light-emitting layer (23A), and has a layer thickness such that only TE0 to TE5 mode light is guided.

7.  The light-emitting diode element according to any one of claims 1 to 6,

    wherein an LED structural layer (20) including the first semiconductor layer (21), the active layer (23), and the second semiconductor layer (25) has a rectangular parallelepiped shape, and a reflective film (51) covering at least four sides of the light-emitting layer (23A) is formed,
    wherein the reflective film (51) is a dielectric multilayer film in which high refractive index films and low refractive index films are alternately stacked, and
    wherein the following formula holds:

$$n_h d_h \cos\alpha = \frac{\lambda}{4} \qquad \text{or} \qquad n_h d_h \cos\alpha = \frac{3\lambda}{4}$$

wherein an emission wavelength of the light-emitting layer (23A) is $\lambda$, an incidence angle of the TE0 mode light is $\alpha$, a refractive index of the high refractive index film is $n_h$, and a film thickness is $d_h$.

8. The light-emitting diode element according to any one of claims 1 to 7,
wherein a center position of the light-emitting layer (23A) coincides with a peak position of a light intensity distribution of the TE0 mode light of the active layer (23).

**Patentansprüche**

1. Lichtemittierendes Diodenelement (10, 50, 61), welches Folgendes aufweist:

ein Substrat (11) mit einem Mottenaugen-Nanomuster (11M) auf einer Oberfläche des Substrates (11), bei welchem kegelförmige Vorsprünge periodisch ausgebildet sind und in einem Gitter angeordnet sind;
eine erste Halbleiterschicht (21), die auf dem Mottenaugen-Nanomuster (11M) geformt ist und eine photonische Kristallschicht (21P) hat;
eine aktive Schicht (23), die auf der ersten Halbleiterschicht (21) geformt ist und eine lichtemittierende Schicht (23A) hat; und
eine zweite Halbleiterschicht (25), die auf der aktiven Schicht (23) geformt ist,
**dadurch gekennzeichnet, dass**

$$P < \lambda/ns$$

erfüllt ist,
wobei P eine Periode der Vorsprünge ist, wobei $\lambda$ eine Emissionswellenlänge der lichtemittierenden Schicht (23A) ist, und wobei ns ein Brechungsindex eines Mediums auf einer Seite der lichtemittierenden Schicht des Mottenaugen-Nanomusters (11M) ist.

2. Lichtemittierendes Diodenelement nach Anspruch 1,

wobei die photonische Kristallschicht (21P) nur photonische Kristalle hat, welche eine quadratische Gitteranordnung und a $\neq$ m$\lambda$w/neff für jede natürliche Zahl m erfüllt, oder wobei die photonische Kristallschicht (21P) nur photonische Kristalle hat, die eine dreieckige Gitteranordnung und a $\neq$ m$\lambda$w x 2/(3/2 x neff) für jegliche natürliche Zahl m hat,
wobei a eine Gitterkonstante der photonischen Kristallschicht (21P) ist, wobei neff ein Brechungsindex eines Materials der ersten Halbleiterschicht (21) ist, und wobei $\lambda$w eine beliebige Wellenlänge in einem Vakuum innerhalb einer vollen Breite bei halber Höhe bzw. Halbwertbreite eines Emissionsspektrums der lichtemittierenden Schicht (23A) ist.

3. Lichtemittierendes Diodenelement nach Anspruch 1 oder 2,

wobei eine erste Schicht (21P) und eine zweite Schicht (25) mit einem effektiven Brechungsindex, der geringer ist als bei der aktiven Schicht (23), so geformt sind, dass die aktive Schicht (23) sandwichartig dazwischen aufgenommen ist, und
wobei die photonische Kristallschicht (21P) die erste Schicht (21P) ist.

4. Lichtemittierendes Diodenelement nach einem der Ansprüche 1 bis 3,

wobei die photonische Kristallschicht (21P) Luftlöcher (22) mit einer zylindrischen Form hat, die an Positionen von quadratischen Gitterpunkten angeordnet sind,
wobei 0,3 $\leq$ d/a erfüllt ist,
wobei a eine Gitterkonstante der Luftlöcher (22) ist, und wobei d ein Durchmesser der Luftlöcher (22) ist.

5. Lichtemittierendes Diodenelement nach Anspruch 4,

wobei die erste Halbleiterschicht (21) aus GaN gemacht ist, und wobei eine Tiefe der Luftlöcher (22) der photonischen Kristallschicht (21P) gleich oder größer als eine Eindringungstiefe eines evaneszenten Lichtes in einem TE0-Modus-Licht von der lichtemittierenden Schicht (23A) ist.

6. Lichtemittierendes Diodenelement nach einem der Ansprüche 1 bis 3,
   wobei eine aktive Schicht (23) eine Abstandsschicht (23B) aufweist, die auf der lichtemittierenden Schicht (23A) geformt ist und eine Schichtdicke der Art hat, dass nur TE0 - TE5-Modus-Licht geleitet wird.

7. Lichtemittierendes Diodenelement nach einem der Ansprüche 1 bis 6,

   wobei eine LED-Strukturschicht (20), welche die erste Halbleiterschicht (21), die aktive Schicht (23) und die zweite Halbleiterschicht (25) aufweist, eine rechteckige Parallelepiped-Form hat, und wobei ein reflektierender Film (51) geformt ist, der mindestens vier Seiten der lichtemittierenden Schicht (23A) bedeckt,
   wobei der reflektierende Film (51) ein dielektrischer mehrlagiger Film bzw. Multilayer-Film ist, in welchem Filme mit hohem Brechungsindex und Filme mit niedrigem Brechungsindex abwechselnd gestapelt sind, und wobei die folgende Formel gilt:

$$n_h d_h \cos\alpha = \frac{\lambda}{4} \quad \text{oder} \quad n_h d_h \cos\alpha = \frac{3\lambda}{4}$$

   wobei $\lambda$ eine Emissionswellenlänge der lichtemittierenden Schicht (23A) ist, wobei $\alpha$ ein Einfallswinkel des TE0-Modus-Lichtes ist, wobei $n_h$ ein Brechungsindex des Films mit hohem Brechungsindex ist, und wobei $d_h$ eine Filmdicke ist.

8. Lichtemittierendes Diodenelement nach einem der Ansprüche 1 bis 7,
   wobei eine mittige Position der lichtemittierenden Schicht (23A) mit einer Peak- bzw. Spitzenposition einer Lichtintensitätsverteilung des TE0-Modus-Lichtes der aktiven Schicht (23) übereinstimmt.

## Revendications

1. Élément diode électroluminescente (10, 50, 61) comprenant :

   un substrat (11) à motif nano en forme d'œil de papillon (11M) sur une surface du substrat (11) dans laquelle des protubérances coniques sont formées périodiquement et sont agencées selon un réseau ;
   une première couche semiconductrice (21) formée sur le nano-motif en œil de papillon (11M) et munie d'une couche de cristal photonique (21P) ;
   une couche active (23) formée sur la première couche semiconductrice (21) et munie d'une couche électroluminescente (23A) ; et
   une deuxième couche semiconductrice (25) formée sur la couche active (23),
   **caractérisé en ce que**

$$P < \lambda/ns$$

   est satisfait,
   dans lequel une période des protubérances est P, une longueur d'onde d'émission de la couche électro-luminescente (23A) est $\lambda$, et un indice de réfraction d'un milieu du côté de la couche électroluminescente du nano-motif œil de papillon (11M) est ns.

2. Élément diode électroluminescente selon la revendication 1,

   dans lequel la couche de cristal photonique (21P) ne comporte que des cristaux photoniques satisfaisant un agencement en réseau carré et a ≠ mλw/neff pour un quelconque entier naturel m, ou la couche de cristal photonique (21P) ne comporte que des cristaux photoniques satisfaisant à un agencement en réseau triangulaire et a ≠ mλw x 2/(3/2 x neff) pour un quelconque entier naturel m,
   dans lequel une constante de réseau de la couche de cristal photonique (21P) est a, un indice de réfraction d'un matériau de la première couche semiconductrice (21) est neff, et une longueur d'onde arbitraire dans le vide dans toute une largeur à mi-hauteur d'un spectre d'émission de la couche électroluminescente (23A) est Aw.

3. Élément diode électroluminescente selon la revendication 1 ou 2,

dans lequel une première couche (21P) et une deuxième couche (25) ayant un indice de réfraction effectif inférieur à celui de la couche active (23) sont formées, la couche active (23) étant interposée entre les deux, et la couche de cristal photonique (21P) est la première couche (21P).

4. Élément diode électroluminescente selon l'une quelconque des revendications 1 à 3, dans lequel la couche de cristal photonique (21P) comporte des trous d'air (22) ayant une forme cylindrique et agencés à des positions de points de réseau carré,

dans lequel $0,3 \leq d/a$ est satisfait
dans lequel une constante de réseau des trous d'air (22) est a et un diamètre des trous d'air (22) est d.

5. Élément diode électroluminescente selon la revendication 4,
dans lequel la première couche semiconductrice (21) est en GaN, et la profondeur des trous d'air (22) de la couche de cristal photonique (21P) est égale ou supérieure à la profondeur de pénétration de la lumière évanescente en mode TE0 provenant de la couche électroluminescente (23A).

6. Élément diode électroluminescente selon l'une quelconque des revendications 1 à 3,
dans lequel la couche active (23) comporte une couche d'espacement (23B) formée sur la couche électroluminescente (23A) et a une épaisseur de couche telle que seule la lumière en mode TE0 à TE5 est guidée.

7. Élément diode électroluminescente selon l'une quelconque des revendications 1 à 6,

dans lequel une couche structurelle LED (20) comportant la première couche semiconductrice (21), la couche active (23) et la deuxième couche semiconductrice (25) a une forme de parallélépipède rectangle, et un film réfléchissant (51) recouvrant au moins quatre côtés de la couche électroluminescente (23A) est formé, dans lequel le film réfléchissant (51) est un film multicouche diélectrique dans lequel des films à indice de réfraction élevé et des films à indice de réfraction faible sont empilés alternativement, et dans lequel la formule suivante est valable :

$$n_h d_h cos\alpha = \frac{\lambda}{4} \qquad ou \qquad n_h d_h cos\alpha = \frac{3\lambda}{4}$$

dans lequel une longueur d'onde d'émission de la couche électroluminescente (23A) est λ, un angle d'incidence de la lumière du mode TE0 est α, un indice de réfraction du film à indice de réfraction élevé est $n_h$ et une épaisseur du film est $d_h$.

8. Élément diode électroluminescente selon l'une quelconque des revendications 1 à 7,
dans lequel une position centrale de la couche électroluminescente (23A) coïncide avec une position de pic d'une distribution d'intensité lumineuse de la lumière du mode TE0 de la couche active (23).

## FIG.1A

## FIG.1B

## FIG.2A

## FIG.2B

## FIG.3A

## FIG.3B

## FIG.4

## FIG.5A

10 — 11 — 11M — 21P — 22 — 23A — 23B — 25A — 25B — 31

## FIG.5B

CMP — 11 — 11M — 91 — 23A — 23B — 25A — 25B — 31

## FIG.6A

## FIG.6B

## FIG.7

$$\boxed{\text{DETERMINE L E D STRUCTURE}}$$

↓

| WAVEGUIDE MODE SIMULATION (EXTRACT LOW-ORDER MODE CONDITIONS) | ～S11 |
|---|---|

↓

| LIGHT INTENSITY DISTRIBUTION SIMULATION (MINIMIZE DISTRIBUTION POSITIONAL DEVIATION) | ～S12 |
|---|---|

↓

| DETERMINE STRUCTURE | ～S13 |
|---|---|

## FIG.8

## FIG.9A

## FIG.9B

## FIG.10

## FIG.11

FIG.12

**EP 4 415 061 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015109477 A

- CN 108511572 A

### Non-patent literature cited in the description

- Efficiency Improvement of Blue LEDs Using a GaN Burried Air Void Photonic Crystal With High Air Filling Fraction. **LIU, JIA-ZHE et al.** IEEE Journal of Quantum Electronics. IEEE, May 2014, vol. 50, 314-320

- **KAZUAKI SAKODA**. Introduction to Photonic Crystal. Morikita Publishing Co., Ltd.